# EUROPÄISCHE PATENTSCHRIFT

(11) **EP 0 769 853 B1**
(45) Veröffentlichungstag und Bekanntmachung des Hinweises auf die Patenterteilung: **04.10.2001**
(21) Anmeldenummer: 95116616.4
(22) Anmeldetag: 21.10.1995
(51) Int. Cl.: H03M 13/00

(54) **Logischer Block für einen Viterbi-Decoder**
Logic block for a viterbi decoder
Bloc logique pour décodeur viterbi

(43) Veröffentlichungstag der Anmeldung: 23.04.1997
(73) Patentinhaber: Micronas GmbH, 79108 Freiburg (DE)
(72) Erfinder: Temerinac, Miodrag, Dr. Ing., D-79258 Hartheim (DE)

(56) Entgegenhaltungen:
- GB-A- 2 216 755
- US-A- 4 536 878
- US-A- 5 416 787
- PATENT ABSTRACTS OF JAPAN vol. 95 no. 5,30.Juni 1995 & JP-A-07 038449 (MATSUSHITA) 7.Februar 1995,

## Beschreibung

Die Erfindung betrifft einen logischen Block für die Decodierung eines Signals, das mittels eines gefalteten Codes codiert ist und der auf der Empfängerseite zu jedem Abtastzeitpunkt durch einen von N möglichen Zuständen definiert ist. Diese N möglichen Zustände werden auch als Datenkanal bezeichnet, weil alle N möglichen Zustände auf der Empfängerseite ausgewertet werden müssen die damit gleichsam einem vorgegebenen Datenkanal entsprechen. Diese spezielle Codierungsart ist von A.J. Viterbi entwickelt worden und beispielsweise ausführlich in "IEEE Transactions on Comunications Technology", Band COM-19, Nr. 5, Oktober 1971, Seiten 751 bis 772 unter dem Titel "Convolutional Codes And Their Performance in Comunication Systems" beschrieben. Sie wird in Anlehnung an den Erfinder meist als Viterbi-Codierung bezeichnet.

Ein Viterbi-Decoder ist beispielsweise in der Patentschrift US 5,416,787 beschrieben. Die ausführliche Beschreibung geht dabei auf alle üblichen Funktionsbausteine ein, die ein Decoder für eine nach einem Viterbi-Faltungscode erzeugte Datenfolge aufweisen muß. Jede derartige Schaltung enthält eine feste Anzahl von Zustandspeichem in denen für jeden möglirchen Zusand jeweils ein zugehöriger Pfad und ein akkumulierter Distanzwert gespeichert ist, ein Steuer- und Rechenwerk zur Bestimmung der neuen Inhalte der Zustandspeicher, ein Distanzrechenwerk zur Bestimmung von Distanzwerten, ein Operator zur Aktivierung von Datenübergängen, und schließlich eine Auswahlschaltung für den wahrscheinlichsten Pfad, vgl. den Oberbegriff des Anspruchs 1. Zur Speicherung der Pfadmetriken verwendet die beschriebene Schaltung nur einen Speicherbaustein und erreicht damit eine Reduktion der Schaltkreisgröße.Auf der Sender- oder Geberseite wird die Redundanz von beliebigen Datenfolgen durch Hinzufügung zusätzlicher Daten erhöht. Die Sicherheit der zu übertragenden oder der zu speichernden Daten wird dabei nicht durch Einbeziehung einer inneren Redundanz erreicht, sondern die Redundanz wird den Daten gezielt hinzugefügt. Hierdurch lassen sich beliebige Datenfolgen gesichert übertragen, wodurch die Viterbi-Codierung sehr universell einsetzbar ist. Ein Anwendungsfall im Konsumbereich ist beispielsweise die Sicherung von digitalisierten Audio-Daten, die entweder in irgendeiner Form übertragen werden oder aus einem digitalen Speichermedium stammen, das infolge der hohen Speicherkapazität Störungen unterworfen ist.

Auf der Empfangsseite wird aus den empfangenen Daten über eine Wahrscheinlichkeitsanalyse, die über eine Vielzahl von empfangenen Datenwörtern geht, bestimmt, welches die wahrscheinlichste Datenfolge ist, die dann der ursprünglichen Information entspricht. Falsch erkannte Daten wirken sich bei der Decodierung nicht nur an einer einzigen Stelle der jeweiligen Datenfolge aus, sondern der Störeinfluß ist gleichsam über einen großen Bereich der Datenfolge verteilt. Damit bleiben die Auswirkungen auf das einzelne Datenwort relativ klein, so daß die Decodierung den richtigen, ungestörten Inhalt des ursprünglichen Signals erkennen und rekonstruieren kann, um ihn am Ausgang des Decodierers zur weiteren Verarbeitung zur Verfügung zu stellen.

Die logischen Blöcke zur Realisierung eines Viterbi-Decoders sind sehr groß, da nicht nur ein größerer Bereich der empfangenen und rekonstruierten Datenfolge gespeichert werden muß, sondern parallel dazu auch die Datenfolgen, die entstanden wären, wenn die momentan empfangenen Datenwörter senderseitig anders gemeint gewesen wären und durch Fehler oder Störungen falsch interpretiert wurden.

Beim Viterbi-Decodierverfahren werden in jedem Abtastzeitpunkt alle N möglichen Empfangszustände daraufhin untersucht, wie gut sie mit den empfangenen Daten zusammenpassen. Dies erfolgt über einen Vergleich von theoretischen Erwartungswerten mit den empfangenen Datenwörtern. Jedem der N möglichen Zustände ist dabei ein fester, digitaler Erwartungswert zugeordnet, der sich nach dem jeweils verwendeten Viterbi-Codierungsverfahren richtet. Aus den empfangenen Datenwörtern und den Erwartungswerten wird der Vergleich mittels einer Distanz- oder Differenzbildung durchgeführt. Je kleiner der Distanzwert ist, desto höher ist die Wahrscheinlichkeit, daß der momentan untersuchte Zustand tatsächlich den empfangenen Datenwörtern zugeordnet ist. Über eine fortlaufende Akkumulierung der Distanzwerte wird die Wahrscheinlichkeitsbetrachtung auch auf die Folge der bereits empfangenen Datenwörter ausgedehnt, so daß die wahrscheinlichste Folge im Laufe der Zeit den kleinsten akkumulierten Distanzwert aufweist. Durch diese akkumulierende Bewertung geht die Einzelstörung gleichsam in der Summe der Gesamtstörungen unter.

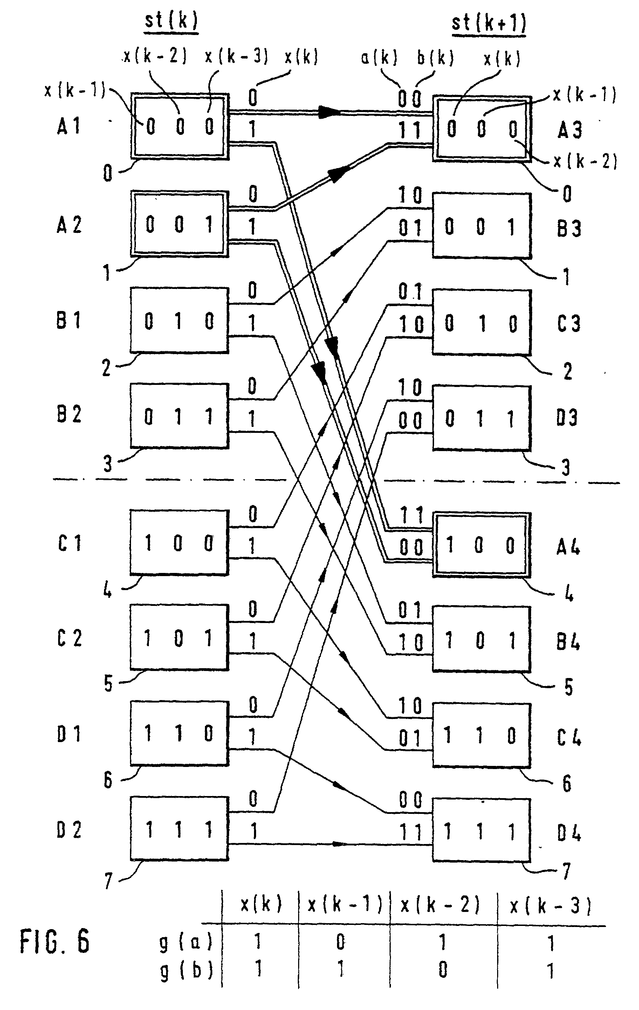

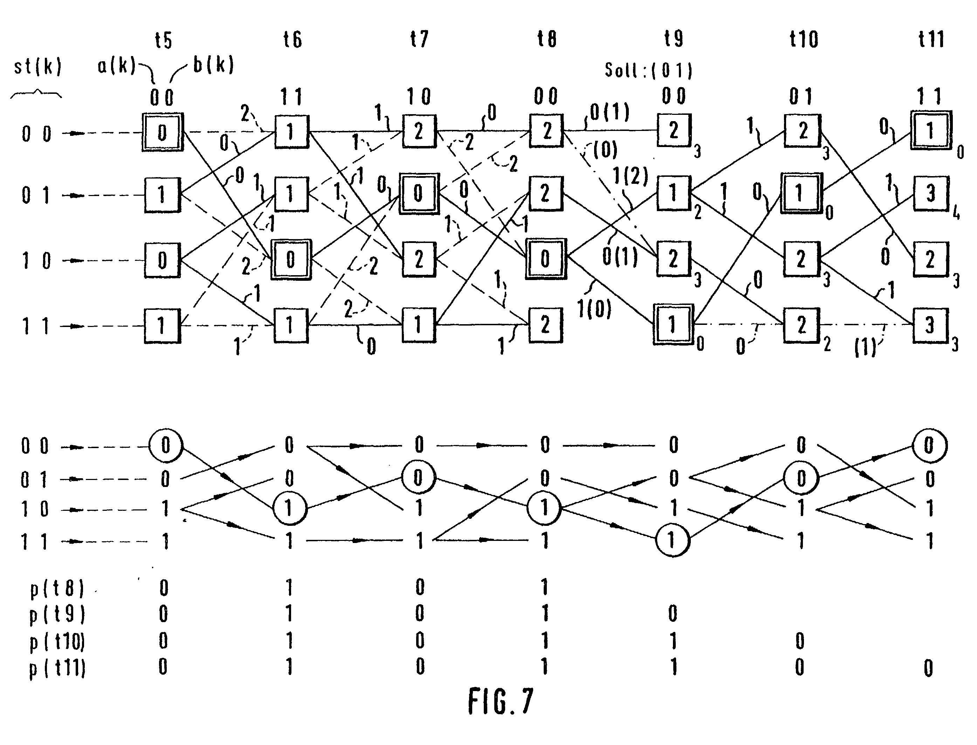

Bei der fortlaufenden Auswertung der addierten Distanzwerte ergeben sich somit eine Vielzahl von Datenfolgen mit unterschiedlichen Wahrscheinlichkeiten, die spätestens nach jedem Datentakt aktualisiert werden müssen. Die einzelne Datenfolge wird dabei als "Pfad" bezeichnet. In graphischer Form - vgl. z.B. Fig. 5 und Fig. 7 - lassen sich die einzelnen Pfade anschaulich in einem Gitterdiagramm, das auch als Trellis-Diagramm bezeichnet wird, darstellen. Das Gitterdiagramm entspricht in horizontaler Richtung einer Zeitachse mit den aufeinanderfolgenden Abtastzeitpunkten und enthält in vertikaler Richtung in einer Art Zeilenanordnung die N unterschiedlichen Zustände. Entsprechend den empfangenen Daten werden nun die Übergänge von einem Zustand auf den nachfolgenden bewertet, indem die zugehörige Distanzbestimmung aus Erwartungswert und Empfangswert durchgeführt wird. Da jeder Zustand mindestens von zwei vorausgehenden Zuständen erreichbar ist, wird auch noch eine Auswahl in dem Sinne getroffen, daß bei Mehrfach-Übergängen jeweils nur derjenige Übergang mit dem kleinerem, allenfalls gleichem akkumulierten Distanzwert weiterverfolgt werden soll. Im Gitterdiagramm stellt die graphische Folge der einzelnen Übergänge anschaulich den jeweiligen Pfad dar. Wenn in den Gitterschnittpunkten die akkumulierten Distanzwerte eingetragen werden, dann ist aus dem Gitterdiagramm sofort der wahrscheinlichste Pfad erkennbar. Die einzelne Pfade haben dabei die Tendenz, daß sie sich anfangs zwar unterscheiden, aber für relativ weit zurückliegende Abtastzeitpunkte in einen einzigen Pfad münden, der dann offensichtlich keine Störeinflüsse mehr enthält und die Folge der ursprünglichen, ungestörten Zustände enthält. Es kann also angenommen werden, daß die Zustände in diesem Bereich korrekt sind und sich daraus mittels einer inversen Viterbi-Codierung die ursprünglichen Daten, die im folgenden auch als Kandidaten bezeichnet werden, wieder bestimmen lassen. Zu jedem Abtastzeitpunkt wird also auch der wahrscheinlichste Kandidat bestimmt, der der Folge der bereits ermittelten Kandidaten hinzugefügt wird, so daß schließlich die Folge der ursprünglichen Daten wieder entsteht.

Diese kurze Beschreibung der Viterbi-Decodierung zeigt, daß eine Vielzahl von Daten in Echtzeit bearbeitet, gespeichert und umgeladen werden müssen. Denn es sind sowohl für jeden der N möglichen Zustände die zugehörigen Pfade als auch die akkumulierten Differenzwerte zu ermitteln und zu speichern. In jedem Zyklus findet außer der Bestimmung der neuen Distanzwerte, der akkumulierten Distanzwerte und der neuen Übergänge auch eine Umladung sämtlicher gespeicherten Pfade statt. Dies ergibt sich anschaulich auch aus den Gitterdiagrammen von Fig. 5 und Fig. 7.

Es ist daher Aufgabe der im Anspruch 1 gekennzeichneten Erfindung, einen im Schaltungsumfang vereinfachten logischen Block für einen flexiblen Viterbi-Decoder anzugeben, der sich auch monolithisch als Zusatz zu einer Signalverarbeitungsschaltung integrieren läßt und der für die Verarbeitung hoher Datenraten geeignet ist.

Ein Ansatz zur Lösung der Aufgabe besteht nach der Erfindung darin, daß der gesamte Verarbeitungsprozeß im Decoder auf gleichförmige, parallel ablaufende Verarbeitungsprozesse hin untersucht wird, um möglichst viele Funktionseinheiten mehrfach ausnutzen zu können.

Die Lösung der Aufgabe besteht in der Angabe einer vorteilhaften Architektur für einen Viterbi-Decoder, die eine erhebliche Reduzierung des Schaltungsaufwandes ermöglicht. Durch die Architektur wird auf vorteilhafte Weise der umfangreiche Datenverkehr im Decoder so organisiert, daß der gleichzeitig ablaufende Datenverkehr im logischen Block auf einen räumlich engen Bereich begrenzt bleibt. Dies wird durch eine optimale Speicherorganisation erreicht, die ermöglicht, daß die große Anzahl von Datenbusleitungen dicht an den einzelnen Zustandsspeichern durch elektronische Schalter oder Multiplexer erheblich reduziert werden kann und für die entfernteren Datenbusse nur noch ein Minimum von Datenleitungen benötigt wird. Soweit wie möglich werden dadurch auch die Adressenrechenwerke vereinfacht, indem ein mit einem Systemtakt verkoppeltes Steuersignal mit seinen alternativen Zuständen zum Umschalten der elektronischen Schalter ausreicht. Letzten Endes wird durch die Gesamtheit der in Anspruch 1 genannten Merkmale eine optimale Speicherorganisation erreicht.

Vorteilhafte Weiterbildungen beziehen sich auf die Bildung der Distanzwerte, weil dort die Ausnutzung systematischer Eigenschaften zur Distanzbildung ausgenutzt wird. Daneben vereinfachen Näherungsverfahren die Distanzwertbestimmung weiter. Schließlich wird auch durch eine vorteilhafte Bereichsbildung die Auflösung bei der Distanzbestimmung erhöht, ohne zusätzliche Signalstellen verarbeiten zu müssen. Dies erhöht die Störunterdrückung besonders bei hohen Rauschpegeln und bewirkt eine deutliche Qualitätsverbesserung bei nur geringfügig erhöhtem Aufwand.

Die Erfindung und vorteilhafte Weiterbildungen werden nun anhand der Figuren der Zeichnung näher beschrieben:
Fig. 1 zeigt schematisch eine bekannte Schaltung zur Bildung eines Viterbi-Codes,
Fig. 2 zeigt zugehörige Impulsdiagramme,
Fig. 3 zeigt zugehörige Daten- und Zustandsfolgen,
Fig. 4 zeigt ein zugehöriges Schema mit N = 4 Zuständen und den zugehörigen Übergängen,
Fig. 5 zeigt ein zugehöriges Gitterdiagramm,
Fig. 6 zeigt schematisch ein Schema für N = 8 Zustände mit einer Speicheranalyse gemäß der Erfindung,
Fig. 7 zeigt zwei ausführliche Gitterdiagramme zu Fig. 2,
Fig. 8 zeigt die Architektur eines logischen Blocks nach der Erfindung,
Fig. 9 zeigt die Distanzwertbestimmung mittels eines Zeitdiagramms und
Fig. 10 zeigt eine vorteilhafte Bereichsbildung bei der Distanzwertbestimmung.

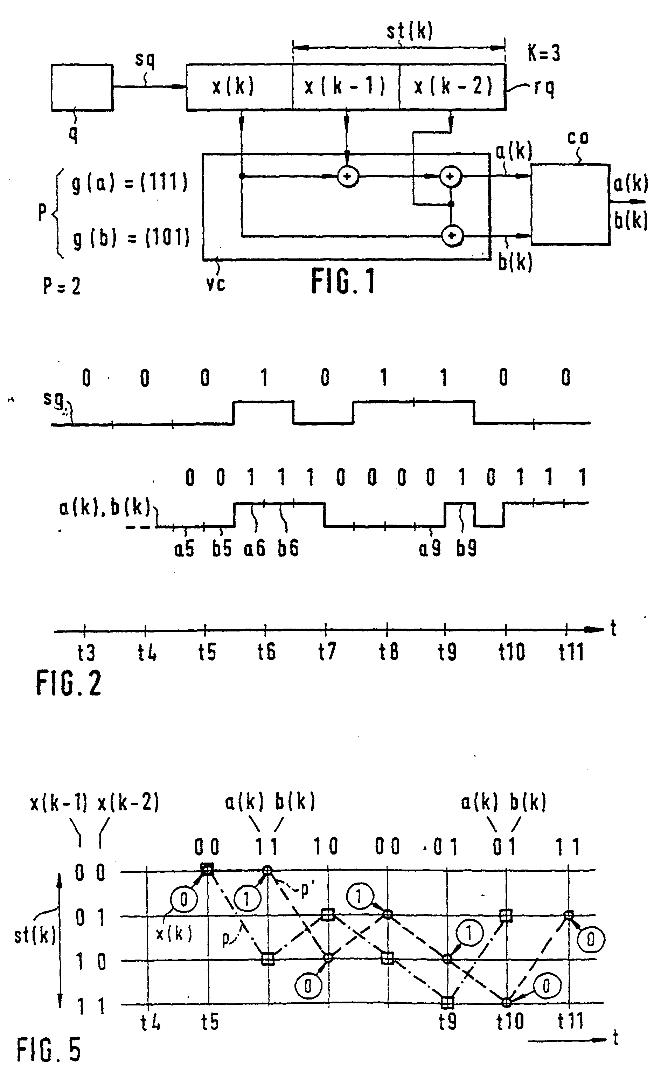

In Fig. 1 ist eine bekannte Schaltung zur Bildung eines Viterbi-Codes dargestellt. Eine Datenquelle q erzeugt eine ursprüngliche Datenfolge sq, die in ein Schieberegister rq mit der Speicherlänge K = 3 eingelesen wird. Die Speicherlänge K ist in der Regel größer. Die gespeicherte Datenfolge sq im Schieberegister enthält die drei aufeinanderfolgenden Bit oder Datenwerte x (k- 2), x (k -1) und x (k), wobei das letztere im Zeitablauf das jüngste Bit ist. Mit k werden im folgenden die einzelnen Abtastzeitpunkte bezeichnet. Entsprechend P = 2 Codierungspolynomen werden aus den gespeicherten Datenwerten neue Codeworte a (k) und b (k) gebildet. Die Bildung dieser Codeworte erfolgt durch einfache additive Verknüpfung der gespeicherten Daten entsprechend den Funktionen g(a) und g(b) im Viterbi-Codierer vc. Das zum Zeitpunkt k entstehende a- und b-Codewort wird mittels einer Kombinationsschaltung co, z.B. einem Multiplexer, in serielle Form gebracht und als codierte Datenfolge a, b am Ausgang abgegeben. Bei der Viterbi-Codierung entstehen in jedem Abtastzeitpunkt k mindestens zwei Codeworte a, b - bei aufwendigen Codierern können jedoch bis zu vier Codewörter gebildet werden.

Bei der Viterbi-Codierung und -Decodierung bildet die gespeicherte Datenfolge im Codierspeicher rq eine wesentliche Rolle und man bezeichnet dies als "Zustand st (k)" zum Zeitpunkt k. Der jeweilige Zustand st (k) wird dabei durch die bereits vorhandene Datenfolge gebildet, also die Daten bis zum Zeitpunkt k - 1, weil das neu hinzukommende Bit (k) erst noch ausgewertet werden muß.

In Fig. 2 ist schematisch anhand eines Zeitdiagramms dargestellt, wie aus der ursprünglichen Datenfolge sq die nach Viterbi codierte Bitfolge a (k), b (k) gebildet wird. Die Bildung erfolgt entsprechend den Polynomen von Fig. 1. Es fällt auf, daß die neue Bitfolge a, b gegenüber der ursprünglichen Bitfolge sq in der Datenrate verdoppelt ist. Die zu den jeweiligen Zeitpunkten gebildeten Codeworte a, b sind angegeben.

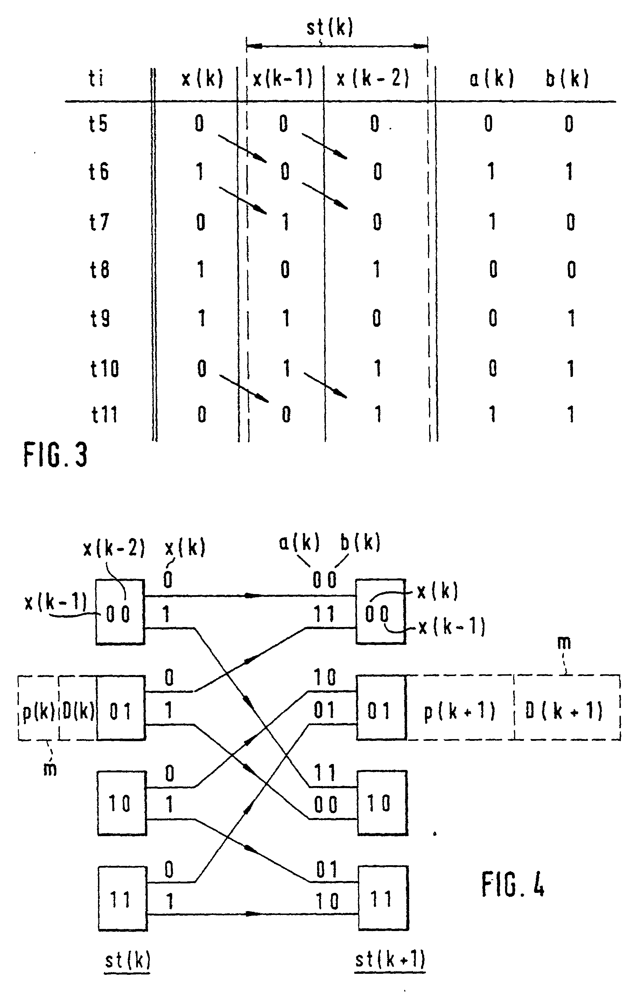

In Fig. 3 ist die Bildung der Datenfolge von Fig. 2 auf etwas andere Weise dargestellt, nämlich über den jeweiligen Inhalt des Schieberegisters rq und die daraus resultierenden Codeworte a(k), b(k). Aus dem jeweiligen Zustand st(k) und dem neu hinzukommenden Bit x (k) werden entsprechend den beiden Polynomen g (a), g (b) die Codeworte gebildet. Dies ist für die Zeitpunkte t5 bis t11 entsprechend Fig. 2 dargestellt. Der Inhalt des Schieberegisters rq verschiebt sich dabei in jedem Abtasttakt um eine Stelle, so daß das neu hinzugekommene Bit x (k) in den Zustandsbereich st (k) gelangt und so lange weiter geschoben wird, bis es von der Speicherlänge K = 3 nicht mehr erfaßt wird.

Eine andere Darstellungsart der Viterbi-Codierung ist in Fig. 4 dargestellt. Die Darstellung entspricht ebenfalls den Polynomen von Fig. 1 und damit der Codierung im Viterbi-Codierer vc. Die Darstellung zeigt acht unterschiedliche Zustandsblöcke" die sich aus den vier möglichen aktuellen Zuständen st (k) und den vier möglichen nachfolgenden neuen Zuständen st (k + 1) zusammensetzen. Das Schema sieht genauso aus, wenn auf der linken Seite der vergangene Zustand st (k 1) und auf der rechten Seite der aktuelle Zustand st (k) dargestellt wird. Jedem Zustandsblock ist dabei eine mögliche Bitkombination eines Zustandes st (k) bzw. st (k + 1) zugeordnet. Die einzelnen Zustandsblöcke sind dabei in auf- oder absteigender Bitfolge geordnet.

Die Schaltungsblöcke auf der linken und rechten Seite sind über gerichtete Verbindungsleitungen miteinander verbunden, die symbolisieren, daß man von einem

Zustand nur auf bestimmte nachfolgende Zustände gelangen kann. Dies ergibt sich beispielsweise durch das Einsetzen der entsprechenden Datenfolge sq in Fig. 1. Die linken Zustandsblöcke st (k) entsprechen genau der Situation des Schieberegisters rq von Fig. 1, wobei das neu hinzukommende Bit x (k) der jeweiligen Übergangslinie zugeordnet ist und rechts neben dem Zustandsblock eingetragen ist. Ist der aktuelle Zustand beispielsweise 00, dann erzeugt ein neu hinzukommendes 0-Bit ebenfalls wieder den Zustand 00. Ist das neu hinzukommende Bit x (k) jedoch 1, dann ändert sich der neue Zustand in die Bitfolge 10. Aus dem Schema ist ersichtlich, daß jeder neue Zustand aus zwei unterschiedlichen Zuständen folgen kann. Die jedem Übergang zugeordneten a-und b-Codeworte a (k), b (k) sind auf der rechten Seite des Schemas dargestellt, und befinden sich unmittelbar neben dem zugehörigen Übergang. Unterschiedliche Polynome g(a), g(b) der Viterbi-Codierung ändern den grundsätzlichen Aufbau des Zustandsschemas nicht, lediglich die codierten Werte a, b an den einzelnen Übergängen ändern sich mit der Änderung der Polynome.

In Fig. 5 ist die Codierung der Datenfolge von Fig. 2 im Gitterdiagramm dargestellt, das wie eingangs erwähnt bei der Viterbi-Codierung oder- Decodierung sehr nützlich ist. Zeilenweise sind dabei die einzelnen Zustände st (k) dargestellt und in horizontaler Richtung die Zeitachse t. Entsprechend den verschiedenen Abtastzeitpunkten k werden nacheinander verschiedene Zustände erreicht, wobei alle aufeinanderfolgenden Zustände durch einen sogenannten Pfad p bzw. p'miteinander verbunden sind. Oberhalb des Gitterdiagramms sind für jeden Zeitpunkt k die zugehörigen a- und b-Codeworte angegeben. Die Verbindungen der einzelnen Zustände, also der Pfad, bildet eine Zackenkurve. Im Gitterdiagramm von Fig. 5 sind zwei parallellaufende Pfade p und p' dargestellt, die sich danach ergeben, ob man den Zustand im Schieberegister rq wie in Fig. 1 betrachtet oder ob man von einem vorherigen Zustand ausgeht. In Fig. 5 entspricht der Pfad p'genau der Bedingung von Fig. und Fig. 2. Dort wo der Pfad p' den jeweiligen Gitterschnittpunkt schneidet, ist in einem Kreis der Bitwert der ursprünglichen Datenfolge sq eingetragen. Da die Zeitachsen von Fig. 2 und Fig. 5 übereinstimmen, ist der Zusammenhang zwischen dem Pfad p'und der ursprünglichen Bitfolge sq und dem codierten Signal a, b recht anschaulich.

In Fig. 6 ist nochmals ein Zustandsschema dargestellt, bei dem die einzelnen Zustände 3 Bitstellen aufweisen. Somit ergeben sich N = 8 möglichen Zustände st (k) und genausoviele für den nachfolgenden Zusand st (k + 1). Unterhalb des Diagramms sind die beiden zugehörigen Polynome g (a) und g (b) dargestellt. Obwohl das Zustandsdiagramm umfangreicher ist als das Zustandsdiagramm von Fig. 2, zeigt es in wesentlichen Punkten Übereinstimmungen, die für die Erfindung ausgenützt werden. Wieder sind jeweils vier Zustandsblöcke über vier Übergänge miteinander verbunden. In Fig. 6 sind die zusammengehörigen Zustandsblöcke jeweils mit gleichen Großbuchstaben dargestellt, wobei die Zustandsblöcke A zur Verdeutlichung hervorgehoben sind.

In Fig. 7 sind nochmals zwei ausführliche Gitterdiagramme dargestellt, die im Zusammenhang mit den Figuren 1 bis 5 zu sehen sind und sich auf die gleichen Abtastzeitpunkte t5 bis t11 beziehen. Dabei soll die ursprüngliche Datenfolge sq von Fig. 2 mittels der Polynome g(a) und g(b) von Fig. 1 codiert werden. Im Zeitbereich t5 bis t8 sind sämtliche Übergänge dargestellt, die nach Fig. 4 möglich sind. In Fig. 7 wird die Empfängerseite betrachtet, die nicht sicher sein kann, daß die empfangenen codierten Daten a, b korrekt sind und daher sind nach Viterbi sämtliche Übergänge und Zustände zu untersuchen. Aus dem Zustandsdiagramm Fig. 4 ergeben sich erwartete Codewerte a, b, die dem einzelnen Übergang zugeordnet sind und die mit den empfangenen Codewerten a (k), b (k) verglichen werden, die oberhalb des Diagramms von Fig. 7 mitangegeben sind. Stimmen die erwarteten und die empfangene Codeworte überein, dann ergibt sich für diesen Übergang der Fehlerwert 0. Besteht bei einem Codewort Gleichheit, bei dem andern aber Ungleichheit, dann entspricht der resultierende Fehler dem Wert 1. Sind schließlich beide Codeworte unterschiedlich, dann hat der Fehler den Wert 2. Da jeder Gitterschnittpunkt über zwei Übergänge erreicht werden kann, scheidet derjenige aus, der den höchsten Fehlerwert aufweist. Der Übersicht wegen ist dieser Übergang in Fig. 7 gestrichelt und der ausgewählte Übergang durchgezogen. Die einzelnen Gitterschnittpunkte sind rechteckförmig, und sie enthalten als Inhalt den akkumulierten Fehlerwert. Zum Zeitpunkt t7 sind beispielsweise zu den vier Zuständen 00 bis 11 die Fehlerwerte 2 bzw. 0 bzw. 2 bzw. 1 aufgelaufen. Zum Zeitpukt t11 sind die entsprechenden Fehlerwerte 1 bzw. 3 bzw. 2 bzw. 3. Damit ist erkennbar, daß wahrscheinlich der vom Zustand 00 zum Zeitpunkt t11 ausgehende Pfad der wahrscheinlich zutreffende Pfad ist, weil er insgesamt die geringsten Fehler aufweist. Die zugehörigen Gitterschnittpunkte sind als Rechtecke mit Doppellinien hervorgehoben.

Um die Auswirkung eines Fehlers darzustellen, ist in Fig. 7 zum Zeitpunkt t9 statt des richtigen Signals b = 1 ein falsches Signal b = 0 empfangen worden. Im richtigen Pfad tritt zum Zeitpunkt t9 somit erstmalig der Fehlerwert 1 auf, während der darüberliegende Zustand einen fehlerfreien Übergang erkennt. Wäre zum Zeitpunkt t9 kein Fehler aufgetreten, dann hätten sich andere akkumulierte Fehlerwerte ergeben, die an den jeweiligen Gitterschnittpunkten rechts unten angegeben sind.

Die Auswahl der Übergänge hängt davon ab, welcher Übergang den kleinsten akkumulierten Fehler liefert. Der jeweilige Übergangsfehler kann dabei durchaus der größere sein. Aus dem Diagramm von Fig. 7 ist auch noch erkennbar, daß einige Pfade zu jüngeren Zeitwerten hin keine Fortsetzung haben und somit gleichsam abbrechen. Andererseits ist zu erkennen, daß bei der zeitlichen Zurückverfolgung der einzelnen Pfade sämtliche Pfade schließlich in einen einzigen Pfad münden, der dann als der wahrscheinlichste anzusehen ist. Beispielsweise gelangt man bei der Rückverfolgung der Pfade vom Zeitpunkt t11 spätestens zum Zeitpunkt t8 in den richtigen Pfad.

In Fig. 7 ist im unteren Teil nochmals das obige Gitterdiagramm dargestellt, wobei in die Gitterschnittpunkte nicht mehr die akkumulierten Fehlerwerte sondern die zugehörigen Bitwerte eingetragen sind. Der besseren Übersicht wegen sind die ausgeschiedenen Übergänge - die im oberen Diagramm gestrichelt dargestellt sind - im unteren Diagramm unterdrückt. Die in die Gitterschnittpunkten eingezeichneten Bitwerte ergeben sich zwangsweise aus dem jeweiligen Übergang, vgl. auch Fig. 4. Dieser rekonstruierte Bitwert ist identisch mit dem zugehörigen Bitwert der ursprünglichen Datenfolge sq. An dieser Stelle ist die Viterbi-Codierung wieder rückgängig gemacht worden, was der gewünschten Decodierung entspricht.

Im unteren Teil von Fig. 4 sind die rekonstruierten Bitfolgen des wahrscheinlichsten Pfades (p) vom Zeitpunkt t8 bis zum Zeitpunkt t11 dargestellt.

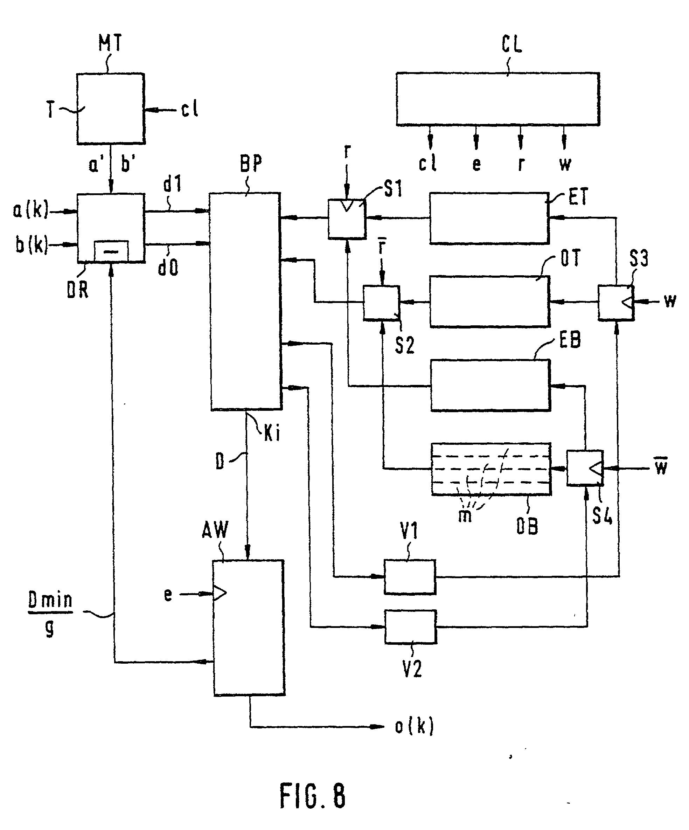

In Fig. 8 ist schematisch der logische Block eines Viterbi-Decoders nach der Erfindung dargestellt. Die Architektur berücksichtigt dabei, daß die grundlegenden Operationen im wesentlichen parallel ausgeführt werden können. Hierzu wird nochmals auf das Zustandsschema von Fig. 6 verwiesen. Die dort hervorgehobenen Zustandsblöcke A1 bis A4 bilden eine in sich geschlossene Gruppe, die für die Viterbi-Operation alle austauschbaren Informationen enthält. Jedem Zustandsblock sind Speichereinrichtungen m (vgl. Fig. 4) für den jeweiligen Pfad p und den jeweiligen akkumulierten Distanzwert D zugeordnet, die im Zustandsschema von Fig. 6 der Übersicht wegen nicht dargestellt sind, jedoch grundsätzlich bekannt sind. Der erste und zweite Zustandsspeicher A1, A2 enthält die zu lesenden Informationen, die zur Bildung der neuen Inhalte des dritten und vierten Zustandsspeichers A3, A4 benötigt werden. Die logische Verknüpfung erfolgt nach den grundlegenden Regeln des Viterbi-Verfahrens in einem Operator BP, dessen Dateneingängen die Inhalte des ersten und zweiten Zustandsspeichers A1, A2 zugeführt werden. Zur Bildung der neuen akkumulierten Distanzwerte D werden dem Operator für jeden der beiden Übergänge auch die zugehörigen 1- und 0-Distanzwerte d1 bzw. d0 aus einer Distanzrecheneinrichtung DR zugeführt, die den Abstand zum logischen 0- und 1-Pegel bestimmen. Hierbei handelt es sich um absolute Distanzwertbestimmungen, die sich aus den analogen Empfangspegeln der Codeworte a (k) bzw. b (k) und gegebenenfalls weiteren ergeben. Zur Distanzbestimmung sind Erwartungswerte a' bzw. b' bzw. andere erforderlich, die aus einer in einem Tabellenspeicher MT gespeicherten Tabelle T zum jeweils untersuchten Zustand st(k) ausgelesen werden. Die gespeicherte Tabelle kann gegebenenfalls umprogrammiert werden oder in unterschiedlichen Sätzen vorliegen, um unterschiedliche Viterbi-Codierungen verarbeiten zu können. Schließlich schreibt der Operator BP die neuen Inhalte über Verzögerungseinrichtungen V1, V2 in den dritten und vierten Zustandsspeicher A3, A4 ein.

Bei der Organisation der N Zustandsspeicher m nach der Erfindung ist es nämlich möglich, nur einen einzigen Satz von N Zustandsspeichern zu verwenden und trotzdem eine oder mehrere Gruppen parallel zu verarbeiten. Dies ermöglichen die Zwischenspeicher V1, V2, die beispielsweise die zu schreibende Information so lange für den vierten Zustandsspeicher A4 zurückhalten, bis dessen alter Inhalt für die Verarbeitung in einer anderen Gruppe, in Fig. 6 die Gruppe C, gelesen worden ist. Der erste Zustandsspeicher A1 macht keine Schwierigkeiten, weil der neue Inhalt in den dritten Zustandsspeicher A3 einzuschreiben ist, der zuvor aber als erster Zustandsspeicher A1 bereits ausgelesen worden ist. Dies entspricht einem üblichen Rückschreiben eines modifizierten Speicherinhaltes in den selben Speicher. Der zweite Zustandsspeicher A2 ist auch unproblematisch, da er erst bei der nachfolgenden Gruppe B mit neuem Inhalt geladen werden muß und somit der Lese- und Schreibvorgang keine Konfliktsituation ergeben.

Wenn die zweite Gruppe B betrachtet wird, dann zeigt sich, daß sie sich ganz ähnlich wie die erste Gruppe A verhält, nur erkennt man nicht so einfach, daß der Zustandsspeicher B3 beim Schreiben keinen Zwischenspeicher erfordert. Dieser wird hingegen wieder beim Zustandsspeicher B4 benötigt, weil der positionsgleiche Zustandsspeicher C2 erst bei der nachfolgenden Gruppe C gelesen wird. Es ist sogar möglich, daß die A- und B-Gruppe bzw. die C- und D-Gruppe auf gleiche Weise parallel verarbeitet werden, wodurch sich die Verarbeitungsgeschwindigkeit verdoppelt. Da reale Viterbi-Codierungen beispielsweise 64 Zustände verarbeiten müssen, erweisen sich derartige Parallel-Verarbeitungsblöcke als äußerst vorteilhaft. Dies um so mehr, wenn der erforderliche Schaltungsaufwand nur unwesentlich erhöht wird.

Besonders einfach wird die Speicherorganisation mit den zugehörigen Lese- und Schreibbussen, wenn den nach binär aufsteigenden Zuständen geordneten N Zustandsspeichern m die Zahlen 0 bis N-1 zugeordnet werden und die Zustandsspeicher danach wie folgt aufgeteilt sind:
die geradzahligen Zustandsspeicher von 0 bis N/2 in einem ersten Bereich ET (= Even Top),
die ungeradzahligen Zustandsspeicher von 1 bis N/2-1 in einem zweiten Bereich OT (= Odd Top),
die geradzahligen Zustandsspeicher von N/2 bis N-2 in einem dritten Bereich EB (= Even Bottom) und schließlich
die ungeradzahligen Zustandsspeicher von N/2+2 bis N-1 in einem vierten Bereich OB (= Odd Bottom).

Nach der Bildung dieser Bereiche kann eine neue Nummerierung vorgenommen werden, bei der jeder Bereich mit einem Startwert, beispielsweise 0, beginnt und bei einem Endwert N/4 - 1 endet. Alle Mitglieder einer Gruppe (z.B.: die Gruppe A) haben dann dieselbe Nummer, die auch als Inkrementadresse anzusehen ist. Diese Speicherorganisation wird im logischen Block von Fig. 8 verwendet. Mittels elektronischer Schalter oder Multiplexer S1 bis S4 werden die jeweils erforderlichen Datenbusse zwischen die einzelnen Bereichen und dem Operator BP geschaltet. Ein Takterzeuger CL bildet die erforderlichen Steuertakte e, r, w und den Systemtakt cl. Die Inkrementierung und deren Steuerung ist in Fig.8 nicht dargestellt.

Die akkumulierten Distanzwerte D und die zugehörigen Kandidaten Ki werden vom Operator BP auch einer Auswahlschaltung AW zugeführt, die den kleinsten Distanzwert Dmin und dadurch den zugehörigen Kandidaten Ki bestimmt, der als rekonstruierter Ausgangsdatenwert o(k) abgegeben wird. Der minimale Distanzwert Dmin wird mit einem Gewichtungsfaktor 1/g (z.B. 1/4) multipliziert und einem Subtrahendeingang der Distanzrecheneinrichtung DR zugeführt, wobei dieser Wert Dmin laufend von den akkumulierten Distanzwerten D abgezogen wird, damit deren Werte nicht überlaufen.

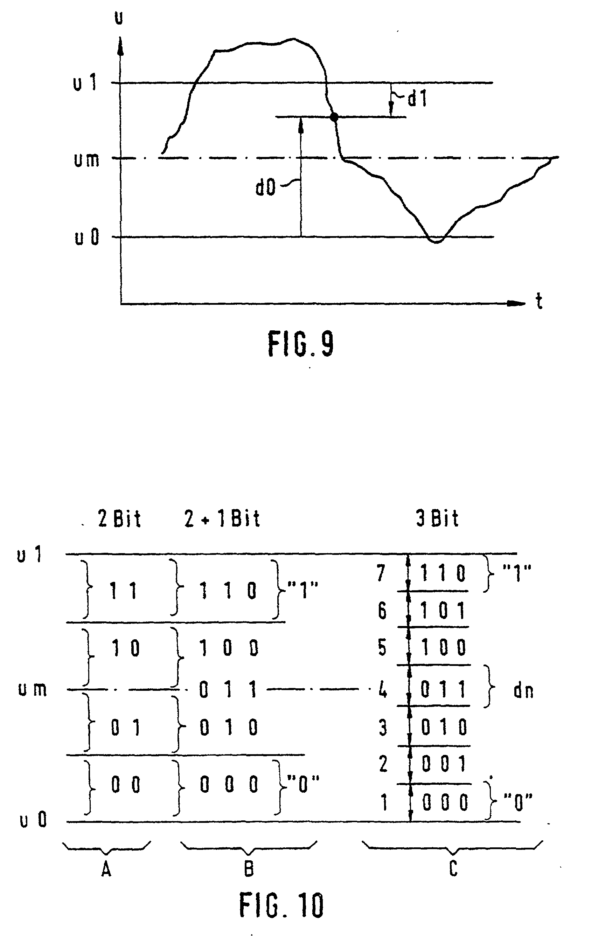

Die Bestimmung der absoluten Distanzwerte d1 bzw. d0 erfolgt entsprechend der Darstellung von Fig. 9. Das empfangene analoge Signal u enthält die digitale Information als logische "0" oder logische "1" entsprechend den vorgegebenen Spannungspegeln u1 und u0. Der jeweilige Abweichungswert d0 bzw. d1 von diesem Spannungspegel liefert die absolute 0- oder 1-Distanz, die entsprechend der Auflösung der A/D-Umsetzung quantisiert ist. Der mittlere Spannungspegel um bildet dabei den Neutralwert, der beim Puncturing-Verfahren verwendet wird. Dadurch wird bekanntlich die zu sendende Datenrate bei der Viterbi-Codierung herabgesetzt.

Da entsprechend Fig. 10 der vorgegebene Spannungsbereich zwischen den Pegeln u0 und u1 durch eine vorgegebene Anzahl von Binärstellen nur in eine gerade Anzahl von Bereichen zerlegt werden kann (vgl. Bereich A), gilt dies sowohl für die absoluten, als auch für die relativen Distanzen. Die relativen Distanzen haben nichts mehr mit der tatsächlichen Spannungsdifferenz zu tun, sondern bezeichnen lediglich mittels Binärzahlen die quantisierte, relative Position. Ein Neutralwert oder eine Neutraldistanz dn, die genau die Mittelspannung um bezeichnet, kann nur mittels eines zusätzlichen Bits gebildet werden. Die Auflösung wird dadurch aber nicht besser, vgl. den Bereich B mit 2+1 Bit. Damit das zusätzliche Bit auch für den gesamten logischen Bereich von 0 bis 1 zur Auflösungsverbesserung verwendet werden kann, wird der Bereich zwangsweise in eine ungerade Anzahl - z.B. 2^{B} - 1 - von Quantisierungsbereichen geteilt, indem die ermittelten Distanzwerte d0, d1 mit (2^{B} -1)/2^{B} multipliziert werden. Damit werden die einzelnen Bereiche gleichmäßig um einen geringfügigen Wert verkleinert, so daß ein zusätzlicher Bereich entsteht. Dies liefert die ungeradzahligen Quantisierungsbereiche. B ist hierbei die Bitstellenanzahl mit der die einzelnen Quantisierungsbereiche codiert sind, dabei ist die Auflösung des A/D-Umsetzers feiner als die Auflösung bei den relativen Distanzangaben mit B Stellen. Jedenfalls hat der mittlere 2B/2-1 der Quantisierungsbereiche (1 bis 7, siehe Figur 10, Bereich 011) dadurch den gleichen Binärwert 011 wie die Neutralposition dn.

## Patentansprüche

1. Logischer Block für die Decodierung einer mittels eines gefalteten Codes codierten Datenfolge, deren zu übertragender Datenkanal in jedem Empfangszeitpunkt (k) durch einen von N möglichen Zuständen (st(k)) definiert ist, dabei enthält der logische Block folgende Teilschaltungen:
- N Zustandsspeicher (m), die als Inhalt jeweils einen zugehörigen Pfad (p) und einen akkumulierten Distanzwert (D) speichern,
- ein Steuer-und-Rechenwerk (DR, BP, AW, CL, S1 bis S4), das aus einem Vergleich der empfangenen Daten (a(k), b(k)) mit den in einer Tabelle (T) gespeicherten Daten (a', b') neue Inhalte der N Zusatzspeicher bildet,
- ein Distanzrechenwerk (DR), das die akkumulierten Distanzwerte (D) und neue Distanzwerte (d1, d2) zur Speicherung in den N-Zustandsspeichern erzeugt,
- ein Operator (BP), der in Abhängigkeit von einem zeitlich am weitesten zurückliegenden Übergang des zugehörigen Pfades (p) als Datenwert einen Kandidat (Ki) bildet, und
- eine Auswahlschaltung (AW), die in Abhängigkeit von den akkumulierten Distanzwerten (D) einen minimalen Distanzwert (Dmin) erzeugt und denjenigen Übergang aktiviert, dessen zugehöriger Kandidat (Ki) als Ausgangsbit (o(k)) abgreifbar ist,
**gekennzeichnet durch** folgende Merkmale:
- die N Zustandsspeicher sind Parallel-Verarbeitungsblöcken zugeordnet, wobei in jedem Parallel-Verarbeitungsblock als eine kleinste, parallel zu verarbeitende Gruppe (A1, A2, A3, A4) ein erster und ein zweiter, jeweils zu lesender Zustandsspeicher (A1, A2) und ein dritter und ein vierter, jeweils zu schreibender Zustandsspeicher (A3,A4) über vier Übergänge miteinander verkoppelt sind,
- die Distanzrecheneinrichtung erzeugt die neuen Distanzwerte (d1, d2) und die akkumulierten Distanzwerte (D) für jeden der vier Übergänge der Gruppe (A1 bis A4),
- der Operator (BP) aktiviert innerhalb der Gruppe (A1 bis A4) in Abhängigkeit vom kleineren akkumulierten Distanzwert (D) für den neu zu schreibenden dritten und vierten Zustandsspeicher (A3, A4) jeweils einen der zwei möglichen Übergänge, und
- die Übergänge für das Schreiben der neuen Inhalte in den dritten und vierten Zustandsspeicher (A3, A4) der aktuellen Gruppe (A) insbesondere für den in einer nachfolgenden Gruppe (C) erst noch auszulesenden vierten Zustandsspeicher (A4) enthalten eine Verzögerungseinrichtung (V1, V2), die dem Zeitausgleich zwischen dem Lesen des alten Inhaltes und dem Schreiben des neuen Inhaltes in der aktuellen Gruppe (A1 bis A4) dient.

2. Logischer Block nach Anspruch 1, **dadurch gekennzeichnet, daß** die N Zustandsspeicher nach binär aufsteigenden Zuständen geordnet sind, wodurch in jeder Gruppe (A1 bis A4) die zu lesenden ersten und zweiten Zustandsspeicher (A1, A2) paarweise, unmittelbar benachbart sind und die zu schreibenden dritten und vierten Zustandsspeicher (A3, A4) um N/2 Speicherpositionen versetzt auseinanderliegen.

3. Logischer Block nach Anspruch 2, **gekennzeichnet durch** folgende Merkmale:
- den nach binär aufsteigenden Zuständen geordneten N Zustandsspeichern sind in aufsteigender Reihenfolge die Zahlen 0 bis N-1 zugeordnet und die N Zustandsspeicher sind entsprechend diesen Zahlen in vier gleiche Bereiche aufgeteilt, wobei
- die geradzahligen Zustandsspeicher von 0 bis N/2-2 einen ersten Bereich (ET),
- die ungeradzahligen Zustandsspeicher von 1 bis N/2-1 einen zweiten Bereich (OT),
- die geradzahligen Zustandsspeicher von N/2 bis N-2 einen dritten Bereich (EB) und
- die ungeradzahligen Zustandsspeicher von N/2+1 bis N-1 einen vierten Bereich (OB) bilden und
- die Adressierung der N Zustandsspeicher erfolgt über den zutreffende Bereich (ET, OT, EB, OB) und eine inkrementierbare Adresse mit der die relative, bei einem Startwert (0) beginnende und bei einem Endwert (N/4-1) endende Position des Zustandsspeichers in dem jeweiligen Bereich definiert ist.

4. Logischer Block nach Anspruch 3, **dadurch gekennzeichnet, daß** das Steuer-und-Rechenwerk (DR, BP, Aw, CL, S1 bis S4) während eines Auswertezyklus zur Ansteuerung der Zustandsspeicher im ersten bis vierten Bereich (ET, OT, EB, OB) die inkrementierbare Adresse vom Startwert (0) aus beginnend bis zum Endwert (N/4-1) inkrementiert und **daß** die Ansteuerung des ersten bis vierten Bereiches nach einer im Steuer-und-Rechenwerk vorgegebenen Folge erfolgt.

5. Logischer Block nach Anspruch 4, **dadurch gekennzeichnet, daß** jeder dieser vier Bereiche (ET, OT, EB, OB) mit einem eigenen Lesebus und einem eigenen Schreibbus verbunden ist und **daß** die Auswahl der vier Lesebusse und der vier Schreibbusse mittels einer vom Steuer-und-Rechenwerk gesteuerten Schalter- oder Multiplexereinrichtung (S1 bis S4) erfolgt.

6. Logischer Block nach einem der Ansprüche 1 bis 5, **dadurch gekennzeichnet daß** die Distanzwerte (d0, d1) aus dem empfangenen Datenpaar (a(k), b(k)) als Abstände zur logischen 0- und 1-Positon in einer Distanzrecheneinrichtung (DR) bestimmt sind.

7. Logischer Block nach einem der Ansprüche 1 bis 6, **dadurch gekennzeichnet, daß** der vom empfangenen Signal vorgegebene, analoge oder logische Distanzbereiche zwischen der logischen 0- und 1-Position in eine ungerade Anzahl (2^{B}-1) von Quantisierungsbereiche aufgeteilt ist und die Quantisierungsbereiche aufeinanderfolgend mittels B Binärstellen codiert sind, wobei der mittlere Quantisierungsbereich (2^{B}/2 -1) auch als neutraler Distanzwert (dn) dient.

8. Logischer Block nach Anspruch 7, **dadurch gekennzeichnet, daß** in der Distanzrecheneinrichtung (DR) die Distanzwerte (d0, d1) mit einem vorgegebenen Faktor ((2^{B}-1) / 2^{B}), der kleiner als der Wert Eins ist, multipliziert sind und von dem erhaltenen Produkt, das als binär codierte Dualzahl vorliegt, die B höchstwertigen Binärstellen zur Bildung relativer Distanzwerte, die den einzelnen Quantisierungsbereichen zugeordnet sind, weiterverwendet werden.

9. Logischer Block nach Anspruch 8, **dadurch gekennzeichnet, daß** zu dem im Stellenumfang unverkürzten Produkt vor der Abstreifung der B Binärstellen ein Offsetwert in der Distanzwertrecheneinrichtung (DR) addiert ist, dessen Wert so vorgegeben ist, **daß** der mittlere Quantisierungsbereich symmetrisch zum neutralen Distanzwert (dn) liegt.

10. Logischer Block nach einem der Ansprüche 1 bis 10, **dadurch gekennzeichnet, daß** der absolute Distanzwert (d1, d2) über ein Näherungsverfahren bestimmt ist.

## Claims

1. A logical block for decoding a data sequence encoded by means of a convolutional code, whose data channel to be transmitted is defined at each instant of reception (k) by one out of N possible states (st(k)), said logical block comprising the following subcircuits:
- N state memories (m) which each store an associated path (p) and an accumulated distance value (D);
- a control and arithmetic section (DR, BP, AW CL, S1 to S4) which forms new contents of the N state memories by comparing the received data (a(k), b(k)) with data (a', b') stored in a table (T);
- a distance computer (DR) which generates the accummulated distance values (D) and new distance values (d1, d2) for storage in the N state memories;
- an operator (BP) which determines a candidate (Ki) as a data value from an oldest transition of the associated path (b); and
- a selection circuit (AW) which generates a minimum distance value (Dmin) from the accumulated distance values (D) and activates the transition whose associated candidate (Ki) is available as an output bit (o(k)),
**characterized by** the following features:
- The N state memories are associated with parallel processing blocks, in each of which a first and a second state memory (A1, A2), which are to be read, and a third and a fourth state memory, which are to be written into (A3, A4), are linked as smallest groups (A1, A2, A3, A4) to be processed in parallel, via four transitions;
- the distance computer generates the new distance values (d1, d2) and the accumulated distance values (D) for each of the four transitions of the group (A1 to A4);
- the operator (BP) activates within the group (A1 to A4) one of the two possible transitions for each of the third and fourth state memories (A3, A4) to be newly written to as a function of the smaller accumulated distance value (D); and
- the transitions for the writing of the new contents into the third and fourth state memories (A3, A4) of the current group (A), particularly for the fourth state memory (A4) yet to be read in a subsequent group (C), comprise a delay device (V1, V2) which serves to compensate for the time difference between the reading of the old contents and the writing of the new contents in the current group (A1 to A4).

2. A logical block as claimed in claim 1, **characterized in that** the N state memories are arranged according to binary ascending states, so that in each of the groups (A1 to A4), the first and second state memories (A1, A2) form adjacent pairs and the third and fourth state memories (A3, A4) are N/2 storage positions apart.

3. A logical block as claimed in claim 2, **characterized by** the following features:
- The N state memories, which are arranged according to binary ascending states, are assigned the numbers 0 to N - 1 in ascending order, and are divided into four like areas in accordance with said numbers,
-- the even-numbered state memories from 0 to N/2-2 forming a first area (ET),
-- the odd-numbered state memories from 1 to N/2-1 forming a second area (OT),
-- the even-numbered state memories from N/2 to N-2 forming a third area (EB), and
-- the odd-numbered state memories from N/2+1 to N-1 forming a fourth area (OB); and
- the N state memories are addressed via the appropriate area (ET, OT, EB, OB) and an incrementable address which defines the relative position of the state memory in the respective area, said position beginning at a start value (0) and ending at an end value (N/4-1).

4. A logical block as claimed in claim 3, **characterized in that** during an evaluation cycle for selecting the state memories in the first to fourth areas (ET, OT, EB, OB), the control and arithmetic section (DR, BP, AW, CL, S1 to S4) increments the incrementable address from the start value (0) to the end value (N/4-1), and that the selection of the first to fourth areas takes place according to a sequence determined in the control and arithmetic section.

5. A logical block as claimed in claim 4, **characterized in that** each of said four areas (ET, OT, EB, OB) is connected to a separate read bus and a separate write bus, and that the selection of the four read buses and the four write buses is made by means of a switch or multiplexer facility (S1 to S4) controlled by the control and arithmetic section.

6. A logical block as claimed in any one of claims 1 to 5, **characterized in that** the distance values (d0, d1) are determined in a distance computer (DR) from the received data pair (a(k), b(k)) as distances to the logic 0 and 1 positions.

7. A logical block as claimed in any one of claims 1 to 6, **characterized in that** the analog or logic distance range between the logic 0 and 1 position, which is determined by the received signal, is divided into an odd number (2^{B}-1) of quantization ranges, and that the quantization ranges are successively encoded with B bits, the middle quantization range (2^{B}/2-1) also serving as a neutral distance value (dn).

8. A logical block as claimed in claim 7, **characterized in that** in the distance computer (DR), the distance values (d0, d1) are multiplied by a predetermined factor ((2^{B}-1)/2^{B}) which is less than the value one, and that of the product obtained, which is present as a binary-coded digit, the B most significant bits are used to form relative distance values, which are assigned to the individual quantization ranges.

9. A logical block as claimed in claim 8, **characterized in that** in the distance computer (DR), prior to the truncation of the B bits, an offset value is added to the product, which is not shortened in terms of its number of bits, said offset value being so preset that the middle quantization range is symmetrical with respect to the neutral distance value (dn).

10. A logical block as claimed in any one of claims 1 to 9, **characterized in that** the absolute distance value (d1, d2) is determined using an approximation method.

## Revendications

1. Bloc logique pour le décodage d'une suite de données codées au moyen d'un code à convolution dont le canal de données à transmettre est défini, à chaque instant (k) de la réception, par un état parmi N états possibles (st(k)), le bloc logique comprenant les circuits partiels suivants :
- N mémoires d'état (m) qui mémorisent, à chaque fois, en tant que contenu, un trajet associé (p) et une valeur de distance cumulée (D),
- une unité de commande et de calcul (DR, BP, AW, CL, S1 à S4) qui forme, à partir d'une comparaison des données reçues (a(k), b(k)) avec les données mémorisées (a', b') dans un tableau (T), les nouveaux contenus des N mémoires d'état (m),
- une unité de calcul des distances (DR) qui produit la valeur de distance cumulée (D) et de nouvelles valeurs de distance (d1, d2) pour la mémorisation dans les N mémoires d'état (m),
- un opérateur (BP) qui forme, en tant que valeur de données, un candidat (Ki), en fonction de la transition la plus en arrière dans le temps du trajet associé (p), et
- un circuit de sélection (AW) qui produit, en fonction des valeurs de distance cumulées (D), une valeur de distance minimale (Dmin) et qui active la transition dont le candidat associé peut être saisi en tant que bit de sortie (o(k))
**caractérisé par les caractéristiques suivantes :**
- les N mémoires d'état (m) sont disposées en blocs de traitement en parallèle et, dans chaque bloc de traitement en parallèle, sous la forme d'un groupe le plus petit à traiter en parallèle, une première et une deuxième mémoires d'état (A1, A2), qui sont à lire à chaque fois, et une troisième et une quatrième mémoires d'état (A3, A4), qui sont à lire à chaque fois, sont couplées entre elles par l'intermédiaire de quatre transitions,
- le dispositif de calcul de distances fournit les nouvelles valeurs de distance (d1, d2) et les valeurs de distance cumulées (D) pour chacune des quatre transitions du groupe (A1 à A4),
- l'opérateur (BP) active, à chaque fois, une des deux transitions possibles, à l'intérieur du groupe (A1 à A4), en fonction de la plus petite valeur de distance cumulée (D), pour les nouvelles troisième et quatrième mémoires d'état (A3, A4) devant être écrites, et
- les transitions pour l'écriture des nouveaux contenus dans les troisième et quatrième mémoires d'état (A3, A4) du groupe actuel (A), en particulier pour la quatrième mémoire d'état (A4) qui est encore à lire dans le groupe suivant (C), comprennent un dispositif de temporisation (V1, V2) qui sert à la compensation du temps entre la lecture de l'ancien contenu et l'écriture du nouveau contenu dans le groupe actuel (A1 à A4).

2. Bloc logique selon la revendication 1, **caractérisé en ce que** les N mémoires d'état (m) sont disposées selon les états croissants en binaire, grâce à quoi, dans chaque groupe (A1 à A4), les première et deuxième mémoires d'état devant être lues (A1, A2) sont disposées par paires en voisinage direct et les troisième et quatrième mémoires d'état (A3, A4) devant être écrites sont séparées l'une de l'autre avec un décalage de N/2 positions de mémoire.

3. Bloc logique selon la revendication 2, **caractérisé par** les caractéristiques suivantes :
- on adjoint aux N mémoires d'état (m) disposées selon les états croissants en binaire, en série croissante, les nombres 0 à N - 1 et les N mémoires d'état (m) sont divisées, en correspondance avec ces nombres, en quatre domaines égaux, dans lesquels :
- les mémoires d'état paires de 0 à N/2 - 2 forment un premier domaine (ET),
- les mémoires d'état impaires de 1 à N/2 - 1 forment un deuxième domaine (OT),
- les mémoires d'état paires de N/2 à N - 2 forment un troisième domaine (EB), et
- les mémoires d'état impaires de N/2 + 1 à N - 1 forment un quatrième domaine (OB), et
- l'adressage des N mémoires d'état (m) est réalisé par l'intermédiaire du domaine concerné (ET, OT, EB, OB) et on définit une adresse pouvant être incrémentée dans le domaine concerné par la position relative de la mémoire d'états commençant à une valeur de départ (0) et finissant à une valeur de fin (N/4 - 1).

4. Bloc logique selon la revendication 3, **caractérisé en ce que** l'unité de commande et de calcul (DR, BP, AW, CL, S1 à S4) incrémente, pendant un cycle d'évaluation, pour la commande des mémoires d'état dans les premier à quatrième domaines (ET, OT, EB, OB), l'adresse pouvant être incrémentée en commençant à partir de la valeur de départ (0) en allant jusqu'à la valeur de fin (N/4 - 1) et **en ce que** la commande des premier à quatrième domaines (ET, OT, EB, OB) est réalisée selon une séquence prédéterminée dans l'unité de commande et de calcul.

5. Bloc logique selon la revendication 4, **caractérisé en ce que** chacun de ces quatre domaines (ET, OT, EB, OB) est relié à un bus de lecture spécifique et à un bus d'écriture spécifique et **en ce que** la sélection des quatre bus de lecture et des quatre bus d'écriture est réalisée au moyen d'un dispositif de commutation ou de multiplexage (S1 à S4) commandé par l'unité de commande et de calcul.

6. Bloc logique selon l'une quelconque des revendications 1 à 5, **caractérisé en ce que** les valeurs de distance (d0, d1) sont déterminées à partir de la paire de données reçue (a(k), b(k)) en tant que distances pour la position logique 0 et la position logique 1 dans un dispositif de calcul de distance (DR).

7. Bloc logique selon l'une quelconque des revendications 1 à 6, **caractérisé en ce que** le domaine de distance analogique ou numérique prédéterminé par le signal reçu entre la position logique 0 et la position logique 1 est divisé en un nombre impair (2^{B} - 1) de domaines de quantification et **en ce que** les domaines de quantification sont codés les uns à la suite des autres au moyen de B positions binaires, le domaine de quantification central (2^{B}/2 - 1) servant aussi de valeur de distance neutre (dn).

8. Bloc logique selon la revendication 7, **caractérisé en ce que**, dans le dispositif de calcul des distances (DR), les valeurs de distance (d0, d1) sont multipliées par un facteur prédéterminé ((2^{B} - 1 / 2^{B})) qui est plus petit que la valeur un et **en ce que**, du produit obtenu, qui se trouve sous la forme d'un nombre binaire codé en binaire, on utilise ensuite les B positions binaires de poids le plus élevé pour former des valeurs de distance relatives qui sont adjointes aux domaines de quantification individuels.

9. Bloc logique selon la revendication 8, **caractérisé en ce que** l'on additionne, au produit non réduit dans sa teneur en positions, avant l'extraction des B positions binaires, dans le dispositif de calcul des valeurs de distance (DR), une valeur de décalage dont la valeur est prédéterminée de telle manière que le domaine de quantification central est symétrique par rapport à la valeur de distance neutre (dn).

10. Bloc logique selon l'une quelconque des revendications 1 à 9, **caractérisé en ce que** la valeur absolue de distance (d1, d2) est déterminée au moyen d'un procédé d'approximation.
